(19) Europäisches Patentamt
European Patent Office
Office européen des brevets

(11) EP 2 375 565 A1

(12) EUROPEAN PATENT APPLICATION

(43) Date of publication:
12.10.2011 Bulletin 2011/41

(51) Int Cl.:
H03F 1/30 (2006.01)    H03F 1/32 (2006.01)
G05F 3/26 (2006.01)

(21) Application number: 10159536.1

(22) Date of filing: 09.04.2010

(84) Designated Contracting States:
AT BE BG CH CY CZ DE DK EE ES FI FR GB GR
HR HU IE IS IT LI LT LU LV MC MK MT NL NO PL
PT RO SE SI SK SM TR
Designated Extension States:
AL BA ME RS

(71) Applicant: NXP B.V.
5656 AG Eindhoven (NL)

(72) Inventors:
• Zahariev, Ivan
Redhill, Surrey RH1 1DL (GB)

• Bratatjandra, Marcel
Redhill, Surrey RH1 1DL (GB)

(74) Representative: Ashton, Gareth Mark
NXP Semiconductors
Intellectual Property and Licensing Department
Betchworth House
57-65 Station Road
Redhill, Surrey RH1 1DL (GB)

(54) **Bias circuit design for bipolar power amplifier linearity improvement**

(57) A bias circuit (2) for a power amplifier (1) comprises a first bipolar transistor (9) arranged to form a current mirror with a bipolar power transistor (8) of the power amplifier (1). The base of the first bipolar transistor (9) is coupled to a first resistor (11), which is in series with a second resistor (10), the second resistor (10) representing an output terminal of the bias circuit (2) for coupling to the base of the bipolar power transistor (8). A second bipolar transistor (12) is coupled via its emitter to the junction of the first (11) and second (10) resistors and is adapted to control the impedance at the junction of the first (11) and second (10) resistors such that the impedance of the bias circuit (2) at the output terminal is substantially dependent on the value of the second resistor (10) alone.

Figure 2

**Description**

This invention relates to a bias circuit for a power amplifier, in particular a monolithic microwave integrated circuit (MMIC) power amplifier, and to a power amplifier incorporating a bias circuit.

Power amplifiers are used in almost all wireless communication systems in order to provide the necessary radiofrequency (RF) signal power for transmission. Recently, new wireless communication technologies such as Wi-Fi, WiMAX, Long Term Evolution (LTE) and Wideband Code Division Multiple Access (WCDMA) have presented new challenges in the design of power amplifiers. Some of these wireless communication systems make use of Orthogonal Frequency Division Multiplexing (OFDM) and require a high degree of linearity in the power amplifiers of wireless basestations to meet the signal-to-noise ratio (SNR) requirements. The frequency of operation of these wireless communication systems makes the use of MMICs for amplifying the RF signal very attractive.

The linearity burden on wireless basestations is exacerbated because they are also being required to deal with the trend to employ modulation schemes that send a higher number of symbols per bit (i.e. more information per unit of bandwidth). However, the channel capacity is restricted by the SNR (as predicted by the Shannon-Hartley Theorem), and this restriction is driving the move towards improvements in linearity of power amplifiers so that basestations can keep up with the demands of new modulation schemes.

At the same time, power amplifiers must also handle the large peak-to-average power ratio (PAR) associated with OFDM. The amplifiers are normally operated at a point somewhat below the 1dB output power compression point ($P_{1dB}$), which is the point at which the output power is 1dB below that predicted from the small signal gain. This helps prevent the high peak-to-average modulated signal from causing clipping at the output of the power amplifier.

In order to ensure high linearity, power amplifiers in wireless basestations are normally operated in Class A. One measurement which is useful in predicting linearity for power amplifiers operated in Class A is the output third order intercept point ($OIP_3$).The difference between $OIP_3$ and $P_{1dB}$ is a useful indicator of the quality of a power amplifier. Typically, this difference is around 10dB. A higher value is desirable because then the amplifier will add less distortion to the linearly modulated signals while it is operated at a fixed output power level. This is advantageous for a basestation architecture as long as the last two high power stages can have relaxed linearity requirements while having a higher power-added efficiency (PAE), i.e. reduced power consumption.

Current high-linearity power amplifiers for basestations are generally made from gallium arsenide (GaAs) due to its high intrinsic linearity. They are characterised by a high value of $OIP_3$, typically lying around 16-17dB above $P_{1dB}$. Companies such as TriQuint Semiconductor (previously WJ Communications), Freescale Semiconductor, Sirenza Micro Devices and Hittite Microwave Corporation manufacture GaAs-based heterojunction bipolar transistors (HBTs) and metal semiconductor field effect transistors (MESFETs). To date, the only silicon-based MMIC power amplifier products are made by Maxim, but these do not have the high linearity required for use in Wi-Fi, WiMax, LTE or WCDMA basestations.

Aside from this, GaAs holds another advantage over silicon because the Johnson limit (the product of breakdown voltage and transition frequency) is about twice as high. A high breakdown voltage is favourable for a high-linearity Class A power amplifier design. However, GaAs technology is much more expensive than silicon, it does not allow such high component integration levels, and has a lower reliability due to its poorer thermal performance.

A bias circuit aimed at improving the linearity of a MMIC power amplifier is disclosed in US6,778,018. The bias circuit employs a biasing transistor arranged as a current mirror with the output transistor of the power amplifier stage. The output of the bias circuit is maintained at a low impedance in order to improve linearity. However, the bias circuit presented is complex, and it generates a high output noise level, which cannot be filtered out by a decoupling capacitor. For this purpose an external inductor is necessary, i.e. an extra component and two extra MMIC and package bondpads. The bias circuitry disclosed in US6,778,018 provides a low baseband impedance via a diode connected transistor. However, this impedance is variable because the diode is a non-linear component. Therefore, it can cause undesired effects on the linearity of the MMIC described in US6,778,018.

In accordance with a first aspect of the invention, there is provided a bias circuit for a power amplifier comprising a first bipolar transistor arranged to form a current mirror with a bipolar power transistor of the power amplifier in use, the base of the first bipolar transistor being coupled to a first resistor, which is in series with a second resistor, the second resistor representing an output terminal of the bias circuit for coupling to the base of the bipolar power transistor, in use; and a second bipolar transistor coupled via its emitter to the junction of the first and second resistors and adapted to control the impedance at the junction of the first and second resistors such that the impedance of the bias circuit at the output terminal is substantially dependent on the value of the second resistor alone.

In accordance with a second aspect of the invention, there is provided a method for biasing a power amplifier comprising arranging a first bipolar transistor to form a current mirror with a bipolar power transistor of the power amplifier in use, coupling the base of the first bipolar transistor to a first resistor, which is in series with a second resistor, coupling the second resistor to the base of the bipolar power transistor, in use; and coupling a second bipolar transistor via its emitter to the junction of the first and second resistors to control the impedance at the junction of the first and second resistors such that the impedance of the circuit formed by the first bipolar transistor, the second bipolar transistor, the first resistor and the second resistor is substantially dependent on the value of the second resistor alone.

By controlling the impedance at the base of the bipolar power transistor in the power amplifier, it can be maintained at a low and constant value. Furthermore, the invention can achieve this goal with a relatively simple circuit, although more complicated embodiments can enhance various aspects of the performance as will become apparent below. The high linearity achieved by the bias circuit according to the invention allows silicon to be used for manufacturing the MMIC, which reduces the cost and improves reliability.

In one embodiment, the second bipolar transistor is arranged in an emitter follower configuration, the collector of the second bipolar transistor being coupled to a DC power supply.

In a first variant of this embodiment, the base of the second bipolar transistor may be coupled to the collector of the first bipolar transistor. In this variant, the collector of the first bipolar transistor is typically supplied with current by a current source coupled to the DC power supply.

In another variant, the base of the second bipolar transistor may be coupled to the output of an operational amplifier, the inverting input of which is coupled to a reference voltage source and the non-inverting input of which is coupled the collector of the first bipolar transistor. In this variant, the collector of the first bipolar transistor is coupled to the DC power supply via a load resistor.

In another embodiment, the emitter of the second bipolar transistor is coupled to the collector of the first bipolar transistor and to the junction of the first and second resistors, the collector of the second bipolar transistor is coupled to the power supply via a load resistor and the base of the second bipolar transistor is coupled to the output of an operational amplifier, the non-inverting input of which is coupled to a reference voltage source and the inverting input of which is coupled to the junction of the collector of the second bipolar transistor and the load resistor.

In this embodiment, the output of the operational amplifier is preferably decoupled with a capacitor.

Typically, the first and second bipolar transistors are silicon transistors.

Preferably, a decoupling capacitor is connected in parallel with the first resistor to filter thermally-generated noise.

Alternatively, or in addition, an inductor may be connected in series with the second resistor. The resistor value can then be decreased or it can be omitted because the inductor compensates for the resulting decrease in impedance. It provides good isolation of the RF signal from the mirror transistor and does not generate thermal noise.

In accordance with a third aspect of the invention, a power amplifier comprises a power bipolar transistor coupled to a bias circuit according to the first aspect of the invention.

Normally, the ratio of the emitter area of the first bipolar transistor to the emitter area of the power bipolar transistor is equal to the ratio of the resistance of the second resistor to the first resistor.

Typically, the power amplifier is adapted to receive an input signal at the base of the power bipolar transistor, in use, via an input impedance matching network.

The collector of the power bipolar transistor is normally adapted for coupling to a load via an output impedance matching network, in use.

Examples of the invention will now be described in detail with reference to the accompanying drawings, in which:

Figure 1 shows a block diagram of a MMIC power amplifier, bias circuit and input matching network;
Figure 2 shows a first embodiment of a bias circuit according to the invention;
Figure 3 shows the spectral components generated by non-linearities in a power amplifier;
Figure 4 shows a second embodiment of a bias circuit according to the invention;
Figure 5 shows a third embodiment of a bias circuit according to the invention;
Figure 6 shows the variation of $P_{1dB}$ with frequency; and
Figures 7 and 8 show the variation of $OIP_3$ with frequency.

The invention provides a power amplifier comprising a bias circuit and an output stage, each of the bias circuit and output stage comprising respective bipolar transistors forming a current mirror, their bases being coupled through a pair of resistors, wherein an auxiliary bipolar transistor is coupled to the junction of the pair of resistors and is operable to control the impedance at the junction so that the impedance of the bias circuit when measured from an input terminal at the junction of a first one of the pair of resistors and the base of the bipolar transistor in the output stage depends substantially on the impedance of the first one of the pair of resistors only.

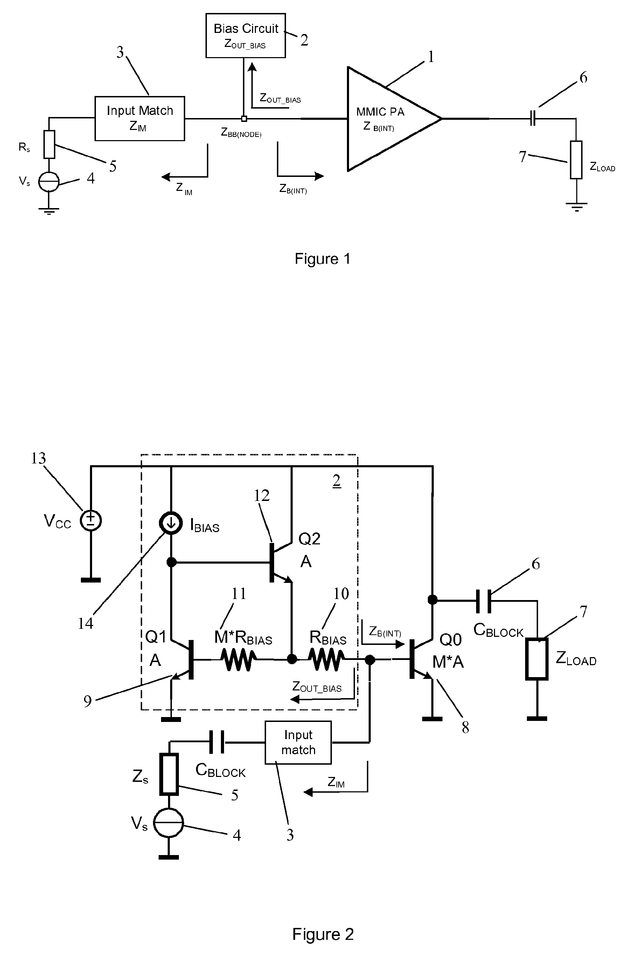

Figure 1 shows a block diagram of an RF power amplifier comprising a power amplifier output stage 1, a bias circuit 2 and an input matching network 3. An RF input signal generated by RF voltage source 4 with source impedance 5 is coupled through the input matching network 3 to the input of the power amplifier output stage 1. The output from the power amplifier output stage 1 is coupled via a DC blocking capacitor 6 to the load impedance 7, which may be an aerial in an actual deployment of the power amplifier.

The bias circuit 2 provides the bias current required so that the power amplifier output stage 1 is operating at the desired quiescent operating point, typically in Class A. In this invention, the design of the bias circuit 2 allows the impedance at the node between the bias circuit 2, power amplifier input stage and input matching network 3 to be controlled to a desired value. The impedance at this node is defined by the parallel combination of the impedance of the input matching network 3, the output impedance of the bias circuit 2 and the input impedance of the power amplifier output stage 1. Thus, using the terminology of Figure 1:

$$Z_{BB(NODE)} = Z_{IM} \| Z_{B(INT)} \| Z_{OUT\_BIAS}$$

where:

Z_{IM} is the output impedance of the input matching network 3
Z_{B(INT)} is the input impedance of the power amplifier output stage 1
Z_{OUT\_BIAS} is the output impedance of the bias circuit 2

The degree by which $Z_{IM}$ and $Z_{B}(_{INT})$ may be adjusted is limited because $Z_{B}(_{INT})$ is dependent on the bias point chosen and $Z_{IM}$ is selected for an optimal small signal gain. However, by specific design of the bias circuit 2 it is possible to allow for $Z_{OUT\_BIAS}$ to be tuned to a desired value, which can influence the overall impedance $Z_{BB(NODE)}$. By judicious choice of $Z_{OUT\_BIAS}$ a low impedance can be achieved that is flat across the baseband frequency range of interest (typically from 0 to 20MHz or more).

Low impedance at the input to the power amplifier output stage 1 leads to low RF voltage and high RF current swings. The low voltage swings reduce the effect that the non-linear transconductance of the bipolar junction transistor in the output stage 1 has on the output current at the collector. As a result, the power amplifier exhibits low third order intermodulation distortion, high $OIP_3$ and high Adjacent Channel Leakage Ration (ACLR). In addition, the low impedance leads to an increase in the breakdown voltage of the bipolar transistor in the output stage 1.

A first embodiment of a bias circuit according to the invention is shown in Figure 2. The bias circuit comprises the components shown within the dashed lines. In the first embodiment, an NPN output transistor 8 of the power amplifier output stage 1 is shown coupled in a current mirror arrangement with a first NPN bipolar transistor 9. The bases of the two transistors 8 and 9 are coupled via resistors 10 and 11. The value of resistor 11 is chosen to be M times greater than the value of resistor 10 to reflect the fact that the emitter area of transistor 8 is M times greater than the emitter area of transistor 9. Other than the difference in emitter areas, the transistors 8 and 9 are identical. Thus, the collector and base currents in transistor 8 are M times higher than those in transistor 9. Typical values of M are 20 and 40. The actual emitter area of transistor 8 is chosen to provide a suitable value for $P_{1dB}$.

The collector circuit of transistor 8 will usually have a inductive or resonant load. This is omitted in Figure 2 for clarity as only the DC condition is of interest here.

A second NPN bipolar transistor 12 is coupled as an emitter follower with its emitter connected to the junction between resistors 10 and 11 and its collector connected to the DC power supply 13. The base is coupled to the collector of the first transistor 9, and this junction is supplied with current from the DC power supply 13 via a current source 14. The purpose of the second transistor 12 is to decrease the effects of variable current gain (normally referred to as β or $h_{fe}$) of the first transistor 9 on the operation of the bias circuit 2. As will be appreciated, the value of β varies both from transistor to transistor and also with temperature and other variables. The second transistor 12 is connected as an emitter follower to provide a very low impedance at the junction between resistors 10 and 11. It reduces the effects of variations in β of the first transistor 9 by a factor of β+1.

Resistor 10 provides isolation between the RF input signal and bias circuit 2. A suitable value for resistor 10 is 15Ω, which has been found to result in optimal linearity. If the resistance of resistor 10 is too low then the isolation will be inadequate, which can cause oscillations. It will also lead to a loss of RF power at the input to the power amplifier output stage 1, which will result in low power-added efficiency (PAE).

Resistor 11 is required to ensure correct operation of the current mirror formed by transistors 8 and 9. Its relatively high value can lead to a high small-signal noise figure due to thermally generated noise from the resistor 11 itself. This can be filtered by a decoupling capacitor (not shown) coupled between the bases of transistors 9 and 12. The value of the capacitor is adjusted to be in the region of 35pF. It also helps to decrease the loop gain of the "beta helper" circuit formed by transistors 9 and 12 and associated components. This ensures stable operation of the bias circuit.

The output impedance of the bias circuit 2 is given by the following equation:

$$Z_{OUT\_BIAS} = R_{BIAS} + \cfrac{1}{g_{m2} + \cfrac{1}{(M \cdot R_{BIAS} + r_{\pi 1})}}$$

where:

R_BIAS is the resistance value of the resistor 10
$g_{m2}$ is the transconductance of transistor 12
M is the ratio of the value of resistor 11 to the value of resistor 10
$r_{\Pi 1}$ is the β of transistor 9 divided by its transconductance

The value of R_BIAS dominates this equation almost entirely so that the impedance of the bias circuit 2 depends substantially on the value of R_BIAS alone.

In the analysis leading to the derivation of the above equation for $Z_{OUT\_BIAS}$, it has been assumed that the capacitances associated with the transistors can be neglected as they typically have values in the region of a few pF, which present a very high impedance at the frequencies of interest, namely 0 to 40MHz. Thus, the value of $Z_{OUT\_BIAS}$ can be made low (for example, 15 Ω) and largely independent of frequency, temperature, the class of operation (e.g. Class A or AB) and the manufacturing process used to make the transistors.

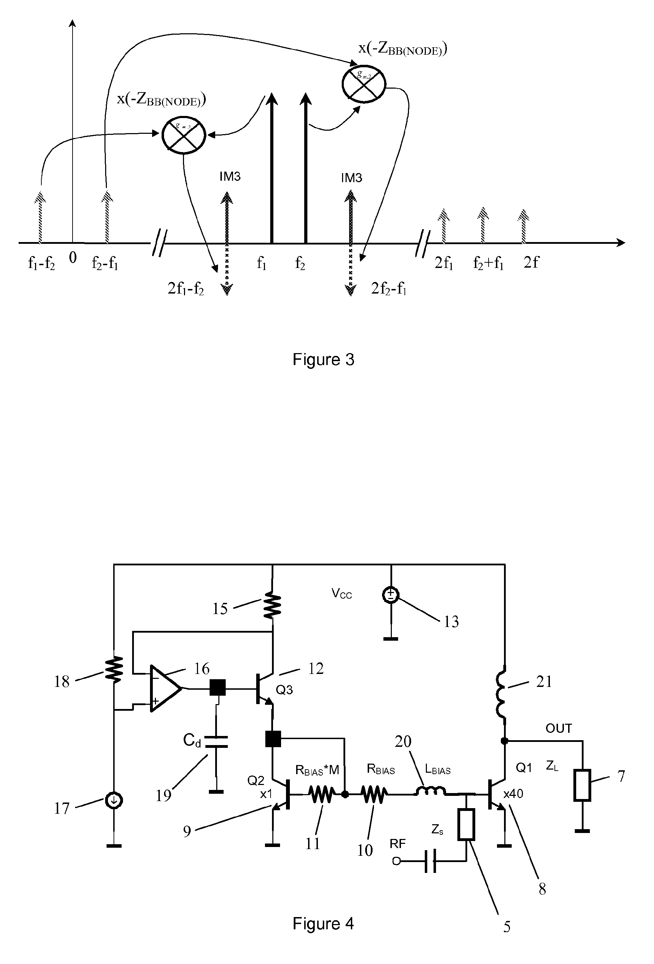

Figure 3 shows the modulation products that will result in a circuit of this type when two signals with frequencies $f_1$ and $f_2$ are caused to mix by the non-linearities in the transistor 8. As can be seen there are the usual harmonic components ($2f_1$ and $2f_2$) along with the sum and difference components ($f_2+f_1$, $f_1-f_2$ and $f_2-f_1$). However, the harmonic components also mix with the sum and difference components to produce third order intermodulation products with frequencies $2f_1-f_2$ and $2f_2-f_1$.

By selecting an appropriate value for $Z_{BB(NODE)}$, it is possible to cause cancellation of the third order intermodulation products referred to above (caused by direct third order mixing) with those caused by indirect second order mixing of the baseband products $f_1-f_2$ and $f_2-f_1$. This is best explained by derivation from a Taylor series approximation of the collector current to base-emitter voltage relationship of a bipolar transistor:

$$i_c(t) = g_m \cdot V_{be}(t) + g_{m2} \cdot V_{be}^2(t) + g_{m3} \cdot V_{be}^3(t)$$

where:

$g_m$ is the first order transconductance term
$g_{m2}$ is the second order transconductance term
$g_{m3}$ is the third order transconductance term

From this approximation, it is possible to derive an expression defining the direct third order mixing products as:

$$\tfrac{3}{4} g_{m3} A^3 \sin(2\omega_2 - \omega_1)t$$

An expression for the indirect second order mixing products can be derived also:

$$g_{m2} A^2 \frac{-Z_{BB(NODE)}}{\beta} g_{m2} A \sin(2\omega_2 - \omega_1)t$$

It can be seen that direct third order mixing products will result in cancellation of the third order intermodulation products if:

$$g_{m2}A^2 \frac{-Z_{BB(NODE)}}{\beta} g_{m2}A = -\tfrac{3}{4}g_{m3}A^3$$

Equations for gm, gm2 and gm3 can be derived as $g_m = \dfrac{I_C}{V_T}$, $g_{m2} = \dfrac{g_m}{2V_T}$, and $g_{m3} = \dfrac{g_m}{6V_T^2}$ · Substitution of these terms into the above equation, shows that cancellation will occur if:

$$Z_{BB(NODE)} = \frac{\beta}{2g_m}$$

It is possible to derive values for the impedances in the circuit by simulation. The value of $Z_{B(INT)}$ is bias dependant, the collector quiescent current being chosen for class AB or class A operation. However, simulation results show a variation of $Z_{B(INT)}$ from 9.9Ω at 1MHz up to 13.8 Ω at 20MHz, although the impedance could be as high as 17-18Ω at higher frequencies, for example 25MHz. In practice, the impedance will have an imaginary part due to parasitic capacitances and inductances, but it is difficult to estimate this and it can be assumed to be negligible. Simulation results show that $Z_{IM}$ has a real part that is in the order of 27.7Ω, the imaginary part varying from 1-20MHz.

In order to calculate a value of $Z_{BB(NODE)}$ that leads to cancellation it is necessary to use the value of Ω under ac (e.g. frequencies of 1 to 20MHz) rather than dc conditions. Simulation results show a typical value of $\beta_{DC}$ is 183. So $\beta_{AC}$ will have a lower value at frequencies from 1-20MHz. In a typical circuit, the value of $g_m$ is 9.25 A/V (based on a collector current of 235mA and a value of $V_T$ of 25.4mV). It has been found that if ROUT_BIAS is chosen to have a value of 15Ω then the value of $Z_{BB(NODE)}$ as given by the equation above will cause considerable cancellation of the third order intermodulation products.

Figure 4 shows a second embodiment of a bias circuit according to the invention. In this circuit, the emitter of the second transistor is connected both to the junction between resistors 10 and 11 and also to the collector of transistor 9. The collector circuit of transistor 12 comprises a series resistor 15 coupled to the power supply 13 and is coupled to the inverting input of an operational amplifier 16.

The non-inverting input of the operational amplifier 16 is held at a reference voltage by coupling it to the junction of a current source 17 and resistor 18, which is coupled to the power supply 13. The current source 17 draws a DC current through resistor 18 causing a voltage drop across the resistor 18. The reference voltage is therefore lower than the supply voltage of power supply 13 by this voltage drop.

The operational amplifier 16 drives the base of transistor 12 such that the voltages on the inverting and non-inverting inputs are very nearly the same. In other words, it causes the transistor 12 to draw a collector current that will establish the same voltage drop across resistor 15 as is present across resistor 18. The vast majority of this collector current in transistor 12 will clearly flow through the collector and emitter of transistor 9, which is then mirrored in transistor 8 to establish the bias condition. The emitter of transistor 12, and hence the junction of resistors 10 and 11, is at a low impedance. Thus, the output impedance is dominated by the value of $R_{BIAS}$ as in the first embodiment.

Although the circuit of Figure 4 can achieve the low impedance required, it does have some disadvantages. These are that the bias current is sensitive to variations in the current gain of transistor 9 and the output impedance will depend on the class of operation. This is due to the diode connection of transistor 9. This type of simple current mirror has an error that comes from the finite forward current gain β. The error is given by $1 + \dfrac{\left(\dfrac{I_{S1}}{I_{S2}}\right)}{\beta}$, where $I_{S1}$ and $I_{S2}$ are the reverse saturation currents of transistors 8 and 9 respectively. The output impedance of this simple current mirror depends on the class of operation because the diode-connected transistor 9 represents a low impedance. Transistor 9 will therefore follow the biasing conditions of transistor 8, i.e. its impedance will change appropriately.

Furthermore, a large decoupling capacitor 19 (in the order of microfarads to farads) is generally required to ensure a low output impedance is achieved. This range of values for the decoupling capacitor value has been checked and optimised by simulation. For example, by increasing the value of the capacitor from the nanofarad to the farad region, the OIP3 simulations show an improvement of about 2dB.

In order to reduce coupling of thermally-generated noise from resistors 10 and 11 to the base of transistor 8, an inductor 20 is provided in series with resistor 10.

The load inductance 21 in the collector circuit of power transistor 8 is also shown.

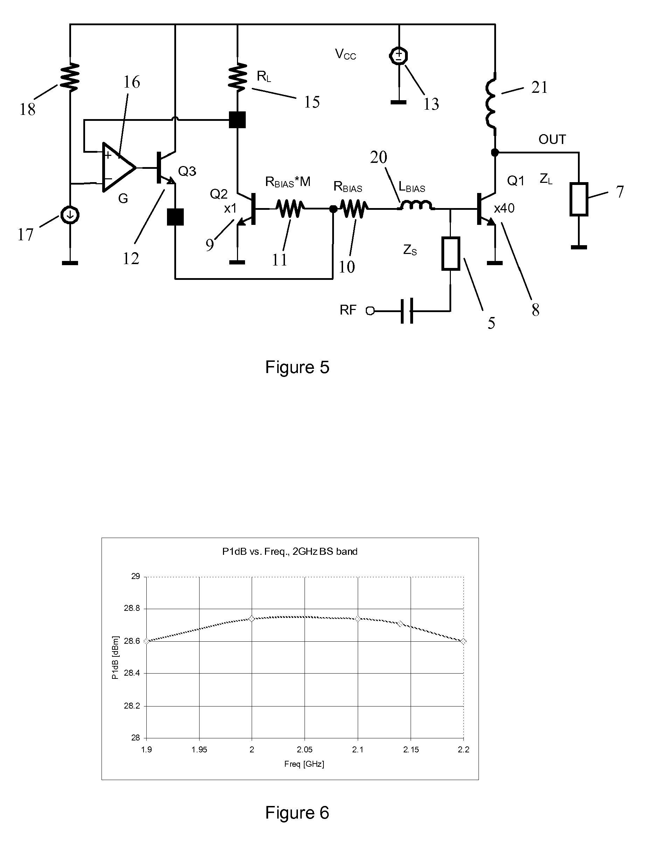

In Figure 5, a third embodiment is shown. In this embodiment, the collector of transistor 12 is coupled directly to the power supply 13 and its emitter is coupled to the junction of resistors 10 and 11 only. The base is coupled to the output of operational amplifier 16.

The non-inverting input of the operational amplifier 16 is coupled to the junction between resistor 15 and the collector of transistor 9. The inverting input is held at a reference voltage by coupling it to the junction of a current source 17 and resistor 18, which is coupled to the power supply 13.

The operational amplifier 16 attempts to keep the voltages on the inverting and non-inverting inputs the same. To this end, it drives the base of transistor 12 so that the emitter biases the base of transistor 9 such that the collector current in transistor 9 causes the same voltage drop across resistor 15 as appears across resistor 18. The bias condition is mirrored by power transistor 8. The negative feedback control through the operational amplifier ensures a bias current that is insensitive to manufacturing process variations, supply voltage and temperature. The low impedance of the emitter of transistor 12 ensures that the output impedance of the bias circuit is independent of the class of operation and is determined substantially by the value of resistor 10 alone.

In order to reduce coupling of thermally-generated noise from resistors 10 and 11 to the base of transistor 8, an inductor 20 is provided in series with resistor 10.

The load inductance 21 in the collector circuit of power transistor 8 is also shown.

The mirror ratio is shown on Figures 4 and 5 as 40:1, but as mentioned above it could instead be 20:1. Indeed, whilst mirror ratios of 20:1 and 40:1 are typical values, the mirror ratio in any of the described embodiments could be any value between 20:1 and 40:1. Although mirror ratios outside this range could be used, we have found that the values in this range, and in particular 20:1 are optimum. This value helps to achieve an optimal layout, which enhances the thermal coupling between the RF power transistor and the transistors forming the mirror. Furthermore, by keeping the value of resistor 10 relatively low, the contribution of this resistor to the RMS thermal noise value is reduced.

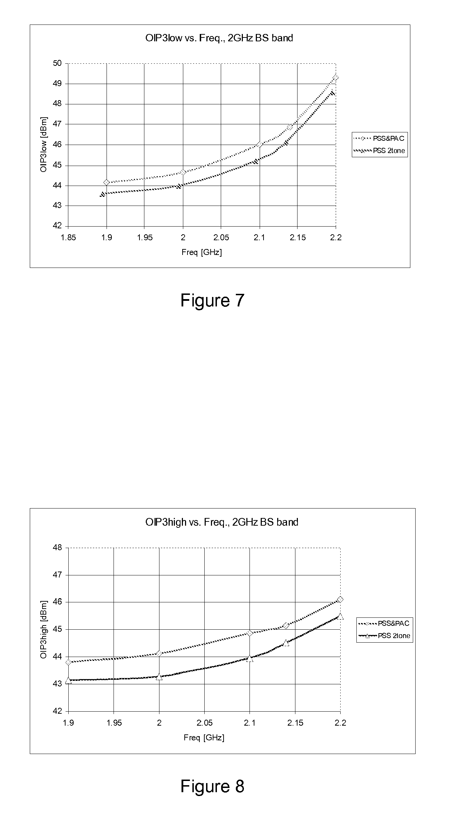

Figures 6, 7 and 8 show simulation results of a power amplifier biased with a circuit according to the embodiment of Figure 2. Specifically, Figure 6 shows the variation of $P_{1dB}$ with frequency whilst Figure 7 shows the variation of $OIP_{3low}$ (the third order intercept point at $2f_1$-$f_2$ as shown on Figure 3) and Figure 8 shows the variation of $OIP_{3high}$ (the third order intercept product at $2f_2$-$f_1$ as shown on Figure 3) with frequency. Each of Figures 7 and 8 show results simulated using two different simulation methods. The first method (PSS & PAC) makes use of one large signal tone and one small signal tone, whereas the second method (PSS 2 tone) makes use of two large signal tones. PSS & PAC typically requires less simulation time but can derive only one of the third order products, whereas PSS 2 tone can derive both. It can be seen that the two methods produce comparable results. As can be seen from these results, the difference between $OIP_3$ and $P_{1dB}$ is at least 14dB and increases with frequency. Despite the fact that silicon is used for fabrication of the device, the difference is comparable with the 16-17dB achieved with GaAs devices.

The invention described herein may be implemented as disclosed in the embodiments. However, many variations are possible without departing from the scope of the invention. For example, PNP rather than NPN transistors may be used, with appropriate changes in the polarity of the power supplies. The circuits may be implemented using field effect transistors instead of (either wholly or in part) bipolar transistors. The bias circuits described may be implemented as integrated circuits or with discrete components. Although silicon, and in particular BiCMOS fabrication will typically be used, other semiconductors, for example a III/V semiconductor such as gallium arsenide may be used. Typically, the power amplifier and bias circuits will be provided as separate integrated circuits. However, they may instead be manufactured on a single MMIC device.

Other variations to the disclosed embodiments can be understood and effected by those skilled in the art in practising the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

**Claims**

1. A bias circuit (2) for a power amplifier (1) comprising a first bipolar transistor (9) arranged to form a current mirror with a bipolar power transistor (8) of the power amplifier (1) in use, the base of the first bipolar transistor (9) being coupled to a first resistor (11), which is in series with a second resistor (10), the second resistor (10) representing an output terminal of the bias circuit (2) for coupling to the base of the bipolar power transistor (8), in use; and a second bipolar transistor (12) coupled via its emitter to the junction of the first (11) and second (10) resistors and adapted to control the impedance at the junction of the first (11) and second (10) resistors such that the impedance of the bias circuit (2) at the output terminal is substantially dependent on the value of the second resistor (10) alone.

2. A bias circuit (2) according to claim 1, wherein the second bipolar transistor (12) is arranged in an emitter follower configuration, the collector of the second bipolar transistor (12) being coupled to a DC power supply (13).

3. A bias circuit (2) according to claim 2, wherein the base of the second bipolar transistor (12) is coupled to the collector of the first bipolar transistor (9).

4. A bias circuit (2) according to claim 3, wherein the collector of the first bipolar transistor (9) is supplied with current by a current source (14) coupled to the DC power supply (13).

5. A bias circuit (2) according to claim 2, wherein the base of the second bipolar transistor (12) is coupled to the output of an operational amplifier (16), the inverting input of which is coupled to a reference voltage source (17, 18) and the non-inverting input of which is coupled the collector of the first bipolar transistor (9).

6. A bias circuit (2) according to claim 5, wherein the collector of the first bipolar transistor (9) is coupled to the DC power supply (13) via a load resistor (15).

7. A bias circuit (2) according to claim 1, wherein the emitter of the second bipolar transistor (12) is coupled to the collector of the first bipolar transistor (9) and to the junction of the first (11) and second (10) resistors, the collector of the second bipolar transistor (12) is coupled to the power supply (13) via a load resistor (15) and the base of the second bipolar transistor (12) is coupled to the output of an operational amplifier (16), the non-inverting input of which is coupled to a reference voltage source (17, 18) and the inverting input of which is coupled to the junction of the collector of the second bipolar transistor (12) and the load resistor (15).

8. A bias circuit (2) according to claim 7, wherein the output of the operational amplifier (16) is decoupled with a capacitor (19).

9. A bias circuit (2) according to any of the preceding claims, wherein the first (9) and second (12) bipolar transistors are silicon transistors.

10. A bias circuit (2) according to any of the preceding claims, wherein a decoupling capacitor is connected in parallel with the first resistor (11) to filter thermally-generated noise.

11. A bias circuit (2) according to any of the preceding claims, wherein an inductor (20) is connected in series with the second resistor (10).

12. A power amplifier comprising a power bipolar transistor (8) coupled to a bias circuit (2) according to any of the preceding claims.

13. A power amplifier according to claim 12, wherein the ratio of the emitter area of the first bipolar transistor (9) to the emitter area of the power bipolar transistor (8) is equal to the ratio of the resistance of the second resistor (10) to the first resistor (11).

14. A power amplifier according to claim 12 or claim 13 adapted to receive an input signal at the base of the power bipolar transistor (8), in use, via an input impedance matching network (3).

15. A method for biasing a power amplifier comprising arranging a first bipolar transistor (9) to form a current mirror with a bipolar power transistor (8) of the power amplifier in use, coupling the base of the first bipolar transistor (9) to a first resistor (11), which is in series with a second resistor (10), coupling the second resistor (10) to the base of the bipolar power transistor (8), in use; and coupling a second bipolar transistor (12) via its emitter to the junction of the first (11) and second (10) resistors to control the impedance at the junction of the first (11) and second (10) resistors such that the impedance of the circuit formed by the first bipolar transistor (9), the second bipolar transistor (12), the first resistor (11) and the second resistor (10) is substantially dependent on the value of the second resistor (10) alone.

Figure 1

Figure 2

Figure 3

Figure 4

Figure 5

Figure 6

Figure 7

Figure 8

Europäisches
Patentamt

European
Patent Office

Office européen
des brevets

# EUROPEAN SEARCH REPORT

Application Number

EP 10 15 9536

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JARVINEN E ET AL: "BIAS CIRCUITS FOR GAAS HBT POWER AMPLIFIERS" 2001 IEEE MTT-S INTERNATIONAL MICROWAVE SYMPOSIUM DIGEST.(IMS 2001). PHOENIX, AZ, MAY 20 - 25, 2001; [IEEE MTT-S INTERNATIONAL MICROWAVE SYMPOSIUM], NEW YORK, NY : IEEE, US LNKD-DOI:10.1109/MWSYM.2001.966942, 20 May 2001 (2001-05-20), pages 507-510, XP001067328 ISBN: 978-0-7803-6538-4 * page 507, left-hand column, line 38 - page 508, right-hand column, line 23; figures 1,2,3 * | 1-6,9-15 | INV. H03F1/30 H03F1/32 G05F3/26 |
| X | EP 1 855 379 A1 (ST MICROELECTRONICS SRL [IT]) 14 November 2007 (2007-11-14) * paragraphs [0012], [0013], [0022] - [0036]; figures 3,7,8 * | 1-4,7,8, 12-15 | |
| X,D | US 6 778 018 B2 (JOLY CHRISTOPHE [US] ET AL JOLY CHRISTOPHE [US] ET AL) 17 August 2004 (2004-08-17) * column 6, lines 38-48; figures 3B,3C * * column 9, line 15 - column 10, line 56; figures 12,13 * | 1-6,9-15 | TECHNICAL FIELDS SEARCHED (IPC) H03F G05F |

-/--

The present search report has been drawn up for all claims

| Place of search | Date of completion of the search | Examiner |
|---|---|---|
| The Hague | 15 September 2010 | Fedi, Giulio |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 10 15 9536

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DEMIREL N ET AL: "A 24 GHz, 18 dBm fully integrated power amplifier in a 0.13Î 1/4 m SiGe HBT technology" RESEARCH IN MICROELECTRONICS AND ELECTRONICS, 2008. PRIME 2008. PH.D, IEEE, PISCATAWAY, NJ, USA, 22 June 2008 (2008-06-22), pages 185-188, XP031303568 ISBN: 978-1-4244-1983-8 * page 186, left-hand column, line 9 - page 187, left-hand column, line 14; figures 1,2 * | 1-4,9, 13-15 | |
| A | US 2006/066405 A1 (BENELBAR REBOUH [US]) 30 March 2006 (2006-03-30) * paragraphs [0003], [0004]; figure 1 * | 1-15 | |

TECHNICAL FIELDS
SEARCHED (IPC)

The present search report has been drawn up for all claims

| Place of search | Date of completion of the search | Examiner |
|---|---|---|
| The Hague | 15 September 2010 | Fedi, Giulio |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

                                                            
& : member of the same patent family, corresponding
   document

EPO FORM 1503 03.82 (P04C01)

**ANNEX TO THE EUROPEAN SEARCH REPORT
ON EUROPEAN PATENT APPLICATION NO.**                     EP 10 15 9536

This annex lists the patent family members relating to the patent documents cited in the above-mentioned European search report.
The members are as contained in the European Patent Office EDP file on
The European Patent Office is in no way liable for these particulars which are merely given for the purpose of information.

15-09-2010

| Patent document cited in search report | | Publication date | Patent family member(s) | | Publication date |
|---|---|---|---|---|---|
| EP 1855379 | A1 | 14-11-2007 | US 2007273448 | A1 | 29-11-2007 |
| US 6778018 | B2 | 17-08-2004 | EP 1410499 | A1 | 21-04-2004 |
| | | | WO 03010885 | A1 | 06-02-2003 |
| | | | JP 2004537212 | T | 09-12-2004 |
| | | | US 2003016083 | A1 | 23-01-2003 |
| | | | US 2003020545 | A1 | 30-01-2003 |
| US 2006066405 | A1 | 30-03-2006 | NONE | | |

For more details about this annex : see Official Journal of the European Patent Office, No. 12/82

**EP 2 375 565 A1**

## REFERENCES CITED IN THE DESCRIPTION

**Patent documents cited in the description**

- US 6778018 B